# EUROPEAN PATENT APPLICATION

(11) **EP 4 632 794 A1**
(43) Date of publication of application: **15.10.2025**
(21) Application number: 23928618.0
(22) Date of filing: 22.03.2023
(51) Int. Cl.: H01L 21/285, B01D 5/00, C23C 16/44, H01L 21/31

(54) **RAW MATERIAL COLLECTION SYSTEM, SUBSTRATE PROCESSING APPARATUS, RAW MATERIAL COLLECTION METHOD, AND METHOD FOR MANUFACTURING SEMICONDUCTOR DEVICE**

(71) Applicant: Kokusai Electric Corporation, Tokyo 101-0045 (JP)
(72) Inventor: YAMAMOTO, Kaoru, Toyama-shi, Toyama 939-2393 (JP); ABURATANI, Yukinori, Toyama-shi, Toyama 939-2393 (JP); HORII, Akira, Toyama-shi, Toyama 939-2393 (JP)
(74) Representative: Verscht, Thomas Kurt Albert
(86) International application number: PCT/JP2023/011171
(87) International publication number: WO 2024/195036

(57) **Abstract**

The present invention comprises: an exhaust pipe that exhausts, from a processing chamber, a processing gas containing a metal-containing raw material, the exhaust pipe having a first exhaust line; a trap unit that is provided on the first exhaust line and that collects the metal-containing raw material from the processing gas; and a heating unit that heats the trap unit in accordance with the viscosity of the metal-containing raw material.

## Description

### [Technical Field]

The present disclosure relates to a source material collection system, a substrate processing apparatus, a source material collection method and a method of manufacturing a semiconductor device.

### [Related Art]

A substrate processing apparatus provided with a trap for recovering and reusing ruthenium (Ru) source material (Ru(EtCp)₂) which did not contribute to a film formation on a substrate is disclosed (see Patent Document 1). In addition, a semiconductor manufacturing apparatus provided with a recovery trap for a tantalum (Ta) source material (Ta(OC₂H₅)₅) is disclosed (see Patent Document 2). In addition, the substrate processing apparatus provided with a bypass pipe configured to bypasses the trap is disclosed (see Patent Document 3).

### [Related Art Document]

### [Patent Document]

Patent Document 1: Japanese Patent Application Laid-Open No. 2006-2174
Patent Document 2: Japanese Patent Application Laid-Open No. 2002-110660
Patent Document 3: Japanese Patent Application Laid-Open No. 2011-35191

### [Disclosure]

### [Technical Problem]

In recent years, for example, a source material such as a liquid whose viscosity changes with a temperature may be used in the film formation. Thereby, it may be difficult to handle such a source material. In addition, it is desirable to recover a source material containing a precious metal from the perspectives of cost and resource conservation.

According to the present disclosure, there is provided a technique capable of recovering a source material whose viscosity changes with a temperature from a gas exhausted from a process chamber in which a substrate is processed.

### [Technical Solution]

According to an embodiment of the present disclosure, there is provided a technique that includes: an exhaust pipe through which a process gas containing a metal-containing source material is exhausted from a process chamber, wherein the exhaust pipe comprises a first exhaust line; a trap structure provided in the first exhaust line and configured to collect the metal-containing source material from the process gas; and a heating structure configured to heat the trap structure in accordance with a viscosity of the metal-containing source material.

### [Advantageous Effects]

As described above, according to some embodiments of the present disclosure, it is possible to recover a source material whose viscosity changes with a temperature from a gas exhausted from a process chamber in which a substrate is processed.

### [Brief Description of Drawings]

FIG. 1 is a diagram schematically illustrating a vertical cross-section of a vertical type process furnace in a substrate processing apparatus according to embodiments of the present disclosure.
FIG. 2 is a diagram schematically illustrating a state in which a process gas flows through a first exhaust line and a trap structure to an abatement apparatus in a source material collection system.
FIG. 3 is a diagram schematically illustrating a trap structure and a storage structure.
FIG. 4A is a diagram schematically illustrating a vertical cross-section of the trap structure.
FIG. 4B is a diagram schematically illustrating a horizontal cross-section taken along a line H - H shown in FIG. 4A.
FIG. 5 is a diagram schematically illustrating a cross-section of a guide structure.
FIG. 6 is a block diagram schematically illustrating a controller and related components of the substrate processing apparatus according to the embodiments of the present disclosure.
FIG. 7 is a diagram schematically illustrating a modified example of a substrate processing according to the embodiments of the present disclosure.
FIG. 8 is a diagram schematically illustrating a state in which the process gas flows through a second exhaust line and the trap structure to the abatement apparatus in the source material collection system.
FIG. 9 is a diagram schematically illustrating a state in which the process gas flows through the first exhaust line and the trap structure to the abatement apparatus in a source material collection system according to a first modified example.

### [Detailed Description]

Hereinafter, embodiments according to the present disclosure will be described mainly with reference to the drawings. For example, the drawings used in the following descriptions are all schematic, and a relationship between dimensions of each component and a ratio of each component shown in the drawing may not always match the actual ones. In addition, even between the drawings, the relationship between the dimensions of each component and the ratio of each component may not always match.

### (1) Configuration of Substrate Processing Apparatus

A substrate processing apparatus 10 includes a process furnace 202 provided with a heater 207 serving as a heating structure (which is a heating device or a heating system). The heater 207 is of a cylindrical shape, and is vertically installed while being supported by a heater base (not shown) serving as a support plate.

An outer tube 203 constituting a reaction vessel (process vessel) is provided in an inner side of the heater 207 to be aligned in a manner concentric with the heater 207. For example, the outer tube 203 is made of a heat resistant material such as quartz (SiO₂) and silicon carbide (SiC). The outer tube 203 is of a cylindrical shape with a closed upper end and an open lower end. A manifold (which is an inlet flange) 209 is provided under the outer tube 203 to be aligned in a manner concentric with the outer tube 203. For example, the manifold 209 is made of a metal such as stainless steel (SUS). The manifold 209 is of a cylindrical shape with open upper and lower ends. An O-ring 220a serving as a seal is provided between an upper end portion of the manifold 209 and the outer tube 203. As the manifold 209 is supported by the heater base, the outer tube 203 is installed vertically.

An inner tube 204 constituting the reaction vessel is provided in an inner side of the outer tube 203. For example, the inner tube 204 is made of a heat resistant material such as quartz (SiO₂) and silicon carbide (SiC). The inner tube 204 is of a cylindrical shape with a closed upper end and an open lower end. The process vessel (reaction vessel) is constituted mainly by the outer tube 203, the inner tube 204 and the manifold 209. A process chamber 201 is provided in a hollow cylindrical portion of the process vessel (that is, an inside of the inner tube 204).

The process chamber 201 is configured to be capable of accommodating a wafer 200 serving as a substrate in a horizontal orientation to be vertically arranged in a multistage manner by a boat 217 described later.

Nozzles 410, 420, 430 and 440 are installed in the process chamber 201 so as to penetrate a side wall of the manifold 209 and the inner tube 204. Gas supply pipes 310, 320, 330 and 340 are connected to the nozzles 410, 420, 430 and 440, respectively. However, the process furnace 202 of the present embodiments is not limited to such a configuration mentioned above.

The gas supply pipes 310, 320, 330 and 340 are connected to an integrated gas system 20. The nozzles 410, 420, 430 and 440 are connected to front ends (tips) of the gas supply pipes 310, 320, 330 and 340, respectively. Each of the nozzles 410, 420, 430 and 440 may be configured as an L-shaped nozzle. Horizontal portions of the nozzles 410, 420, 430 and 440 are installed so as to penetrate the side wall of the manifold 209 and the inner tube 204. Vertical portions of the nozzles 410, 420, 430 and 440 are installed in a preliminary chamber 201a of a channel shape (a groove shape) protruding outward in a radial direction of the inner tube 204 and extending in the vertical direction. That is, the vertical portions of the nozzles 410, 420, 430 and 440 are installed in the preliminary chamber 201a to extend upward (in a direction in which the wafers 200 are arranged) along an inner wall of the inner tube 204.

The nozzles 410, 420, 430 and 440 extend from a lower region of the process chamber 201 to an upper region of the process chamber 201. The nozzles 410, 420, 430 and 440 are provided with a plurality of gas supply holes 410a, a plurality of gas supply holes 420a, a plurality of gas supply holes 430a and a plurality of gas supply holes 440a facing the wafers 200, respectively. Thereby, process gases can be supplied to the wafers 200 through the gas supply holes 410a of the nozzle 410, the gas supply holes 420a of the nozzle 420, the gas supply holes 430a of the nozzle 430 and the gas supply holes 440a of the nozzle 440, respectively. The gas supply holes 410a, the gas supply holes 420a, the gas supply holes 430a and the gas supply holes 440a are provided from a lower portion to an upper portion of the inner tube 204. An opening area of each of the gas supply holes 410a, the gas supply holes 420a, the gas supply holes 430a and the gas supply holes 440a is the same, and each of the gas supply holes 410a, the gas supply holes 420a, the gas supply holes 430a and the gas supply holes 440a is provided at the same pitch. However, the gas supply holes 410a, the gas supply holes 420a, the gas supply holes 430a and the gas supply holes 440a are not limited thereto. For example, the opening area of each of the gas supply holes 410a, the gas supply holes 420a, the gas supply holes 430a and the gas supply holes 440a may gradually increase from the lower portion to the upper portion of the inner tube 204. Thereby, it is possible to further uniformize a flow rate of a gas supplied through the gas supply holes 410a, the gas supply holes 420a, the gas supply holes 430a or the gas supply holes 440a.

The gas supply holes 410a of the nozzle 410, the gas supply holes 420a of the nozzle 420, the gas supply holes 430a of the nozzle 430 and the gas supply holes 440a of the nozzle 440 are provided within a height range from a lower portion to an upper portion of the boat 217 described later. Therefore, the process gases supplied into the process chamber 201 through the gas supply holes 410a, the gas supply holes 420a, the gas supply holes 430a and the gas supply holes 440a are supplied onto the wafers 200 accommodated in the boat 217 from the lower portion to the upper portion thereof, that is, an entirety of the wafers 200 accommodated in the boat 217. It is preferable that the nozzles 410, 420, 430 and 440 extend from the lower region to the upper region of the process chamber 201. However, the nozzles 410, 420, 430 and 440 may preferably extend only to the vicinity of a ceiling of the boat 217.

A metal-containing gas (which is a source gas containing a metal element) is supplied into the process chamber 201 through the integrated gas system 20, the gas supply pipe 310 and the nozzle 410. The source gas serves as one of the process gases.

A reducing gas serving as one of the process gases is supplied into the process chamber 201 through the integrated gas system 20, the gas supply pipe 320 and the nozzle 420.

An oxygen-containing gas (which is a gas containing an oxygen (O) atom) serving as one of the process gases is supplied into the process chamber 201 through the integrated gas system 20, the gas supply pipe 330 and the nozzle 430.

A halogen-containing gas (which is a gas containing a halogen element) serving as one of the process gases is supplied into the process chamber 201 through the integrated gas system 20, the gas supply pipe 340 and the nozzle 440.

An inert gas is supplied from the integrated gas system 20 into the process chamber 201 through each of the nozzles 410, 420, 430 and 440.

As the inert gas, for example, nitrogen (N₂) gas, or a rare gas such as argon (Ar) gas, helium (He) gas, neon (Ne) gas and xenon (Xe) gas may be used. As the inert gas, one or more of the gases exemplified above may be used. The same also applies to other inert gases described later

A process gas supplier is constituted mainly by the gas supply pipes 310, 320, 330 and 340 and the nozzles 410, 420, 430 and 440. However, the process gas supplier may be constituted by only the nozzles 410, 420, 430 and 440. The process gas supplier may also be simply referred to as a "gas supplier". When the metal-containing gas is supplied through the gas supply pipe 310, a metal-containing gas supplier is constituted mainly by a part of the integrated gas system 20 and the gas supply pipe 310. However, the metal-containing gas supplier may further include the nozzle 410. In addition, when the reducing gas is supplied through the gas supply pipe 320, a reducing gas supplier is constituted mainly by a part of the integrated gas system 20 and the gas supply pipe 320. However, the reducing gas supplier may further include the nozzle 420. In addition, when the oxygen-containing gas is supplied through the gas supply pipe 330, an oxygen-containing gas supplier is constituted mainly by a part of the integrated gas system 20 and the gas supply pipe 330. However, the oxygen-containing gas supplier may further include the nozzle 430. In addition, when the halogen-containing gas is supplied through the gas supply pipe 340, a halogen-containing gas supplier is constituted mainly by a part of the integrated gas system 20 and the gas supply pipe 340. However, the halogen-containing gas supplier may further include the nozzle 440. In addition, an inert gas supplier (which is an inert gas supply system) is constituted mainly by a part of the integrated gas system 20. The inert gas supplier may also be referred to as a "rare gas supplier".

According to the present embodiments, the gases are supplied into a vertically long annular space (which is defined by the inner wall of the inner tube 204 and edges (peripheries) of the wafers 200) through the nozzles 410, 420, 430 and 440 provided in the preliminary chamber 201a. Then, the gases are ejected into the inner tube 204 through the gas supply holes 410a of the nozzle 410, the gas supply holes 420a of the nozzle 420, the gas supply holes 430a of the nozzle 430 or the gas supply holes 440a of the nozzle 440 provided at the positions facing the wafers 200. More specifically, the gases such as the process gases are ejected into the inner tube 204 in a direction parallel to surfaces of the wafers 200 through the gas supply holes 410a of the nozzle 410, the gas supply holes 420a of the nozzle 420, the gas supply holes 430a of the nozzle 430 and the gas supply holes 440a of the nozzle 440, respectively.

An exhaust hole (which is an exhaust port) 204a is a through-hole facing the nozzles 410, 420, 430 and 440, and is provided at a side wall of the inner tube 204. For example, the exhaust hole 204a may be of a narrow slit-shaped through-hole elongating vertically. The gases supplied into the process chamber 201 through the gas supply holes 410a of the nozzle 410, the gas supply holes 420a of the nozzle 420, the gas supply holes 430a of the nozzle 430 or the gas supply holes 440a of the nozzle 440, respectively, flow over the surfaces of the wafers 200. The gases that flowed over the surfaces of the wafers 200 are exhausted through the exhaust hole 204a into an exhaust path 206 (which is constituted by a gap provided between the inner tube 204 and the outer tube 203). The gases flowing in the exhaust path 206 flow into an exhaust pipe 231 and are then discharged (exhausted) out of the process furnace 202.

The exhaust hole 204a is provided to face the wafers 200. The gases supplied to the vicinity of the wafers 200 in the process chamber 201 through the gas supply holes 410a, the gas supply holes 420a, the gas supply holes 430a or the gas supply holes 440a flow in the horizontal direction. The gases that flowed in the horizontal direction are exhausted through the exhaust hole 204a into the exhaust path 206. The exhaust hole 204a is not limited to the slit-shaped through-hole. For example, the exhaust hole 204a may be configured as a plurality of holes.

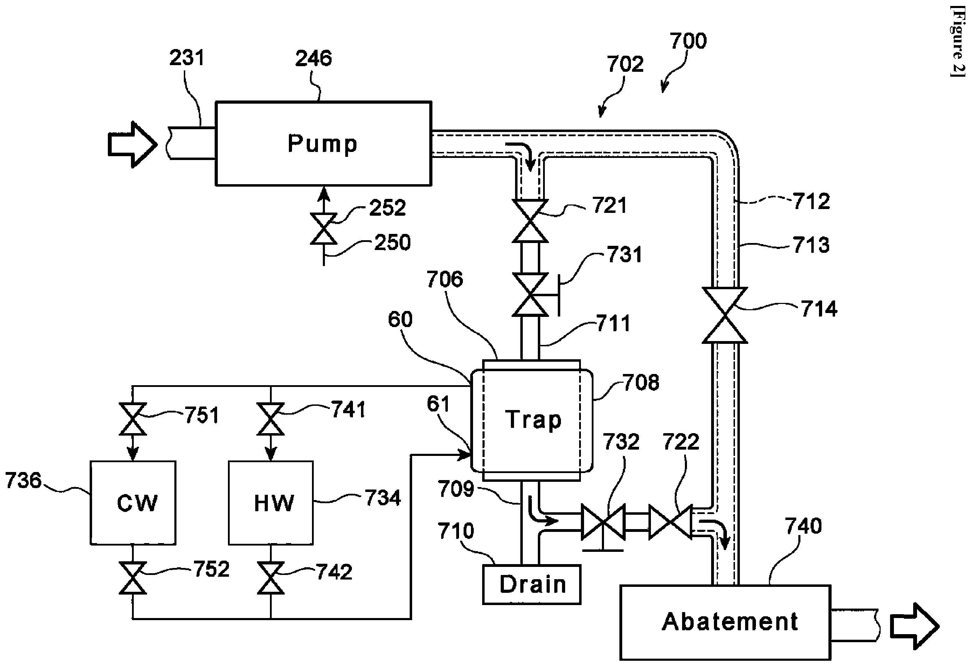

The exhaust pipe 231 through which an atmosphere (inner atmosphere) of the process chamber 201 is exhausted is installed at the manifold 209. A pressure sensor 245 serving as a pressure detector (pressure detecting structure) configured to detect a pressure (inner pressure) of the process chamber 201, an APC (Automatic Pressure Controller) valve 243 and an exhaust system 700 are sequentially connected to the exhaust pipe 231 in this order from an upstream side to a downstream side of the exhaust pipe 231 in a gas flow direction. As shown in FIG. 2, the exhaust system 700 includes a vacuum pump 246 serving as a pump, a source material collection system 702 and an abatement apparatus 704 serving as a detoxification apparatus. With the vacuum pump 246 in operation, the APC valve 243 may be opened or closed to perform a vacuum exhaust of the process chamber 201 or stop the vacuum exhaust. In addition, with the vacuum pump 246 in operation, an opening degree of the APC valve 243 may be adjusted in order to adjust the inner pressure of the process chamber 201. An exhauster (which is an exhaust system) is constituted mainly by the exhaust hole 204a, the exhaust path 206, the exhaust pipe 231, the APC valve 243, the pressure sensor 245 and the source material collection system 702 in the exhaust system 700. The exhauster may further include the vacuum pump 246.

A seal cap 219 serving as a furnace opening lid capable of airtightly sealing (closing) a lower end opening of the manifold 209 is provided under the manifold 209. The seal cap 219 is in contact with the lower end of the manifold 209 from thereunder. For example, the seal cap 219 is made of a metal such as SUS, and is of a disk shape. An O-ring 220b serving as a seal is provided on an upper surface of the seal cap 219 so as to be in contact with the lower end of the manifold 209. A rotator (which is a rotating structure) 267 configured to rotate the boat 217 accommodating the wafers 200 is provided at the seal cap 219 in a manner opposite to the process chamber 201. A rotating shaft 255 of the rotator 267 is connected to the boat 217 through the seal cap 219. The rotator 267 is configured to rotate the wafers 200 by rotating the boat 217. The seal cap 219 is configured to be elevated or lowered in the vertical direction by a boat elevator 115 serving as an elevating structure vertically provided outside the outer tube 203. By elevating and lowering the seal cap 219 in the vertical direction, the boat elevator 115 is configured to be capable of transferring (loading) the boat 217 into the process chamber 201 and capable of transferring (unloading) the boat 217 out of the process chamber 201. The boat elevator 115 serves as a transfer structure (transfer system) that loads the boat 217 and the wafers 200 accommodated in the boat 217 into the process chamber 201 or that unloads the boat 217 and the wafers 200 accommodated in the boat 217 out of the process chamber 201.

The boat 217 serving as a substrate support is configured to accommodate (or support) the wafers 200 (for example, 25 wafers to 200 wafers) while the wafers 200 are horizontally oriented with their centers aligned with one another with a predetermined interval therebetween in the vertical direction. For example, the boat 217 is made of a heat resistant material such as quartz and SiC. A lower portion of the boat 217 is supported by a heat insulating cylinder 218 configured as a cylinder made of a heat resistant material such as quartz and SiC. With such a configuration, the heat insulating cylinder 218 suppresses the transmission of the heat from the heater 207 to the seal cap 219. However, the present embodiments are not limited thereto. For example, instead of the heat insulating cylinder 218, a plurality of heat insulating plates horizontally oriented are placed under the boat 217 in a multistage manner (not shown) to support the lower portion of the boat 217.

A temperature sensor (not shown) serving as a temperature detector is installed in the inner tube 204. An amount of the electric current supplied (or applied) to the heater 207 is adjusted based on temperature information detected by the temperature sensor such that a desired temperature distribution of a temperature (inner temperature) of the process chamber 201 can be obtained. Similar to the nozzles 410, 420, 430 and 440, the temperature sensor is L-shaped, and is provided along the inner wall of the inner tube 204.

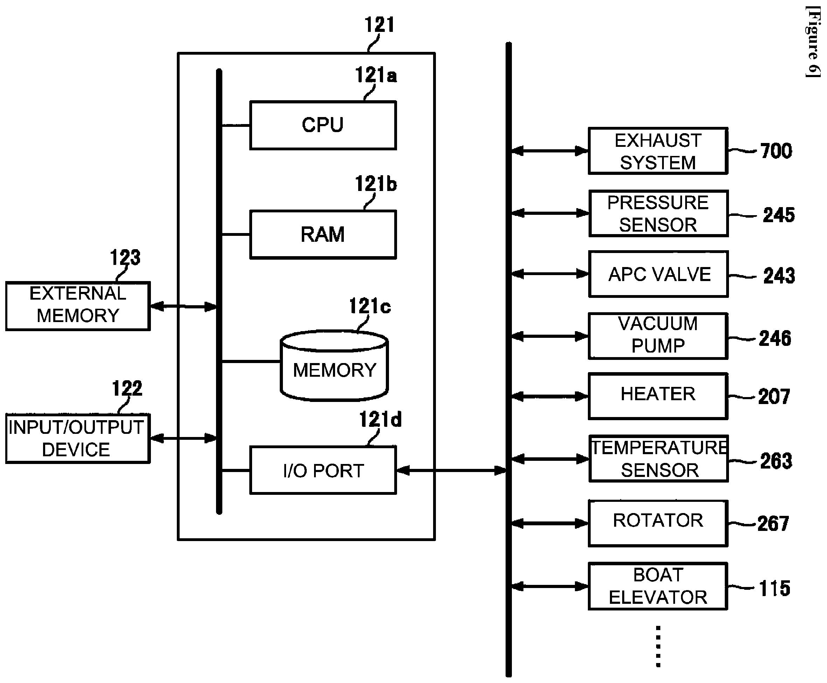

As shown in FIG. 6, a controller 121 serving as a control device (or a control structure) is constituted by a computer including a CPU (Central Processing Unit) 121a, a RAM (Random Access Memory) 121b, a memory 121c and an I/O port 121d. The RAM 121b, the memory 121c and the I/O port 121d are configured to be capable of exchanging data with the CPU 121a through an internal bus. For example, an input/output device 122 constituted by a component such as a touch panel is connected to the controller 121.

The memory 121c is configured by a component such as a flash memory and a hard disk drive (HDD). For example, a control program configured to control an operation of the substrate processing apparatus or a process recipe containing information on procedures and conditions of a method of manufacturing a semiconductor device (substrate processing method) described later is readably stored in the memory 121c. The process recipe is obtained by combining steps (procedures) of the method of manufacturing the semiconductor device (substrate processing method) described later such that the controller 121 can execute the steps to acquire a predetermined result, and functions as a program. Hereafter, the process recipe and the control program may be collectively or individually referred to as a "program". Thus, in the present specification, the term "program" may refer to the process recipe alone, may refer to the control program alone, or may refer to a combination of the process recipe and the control program. The RAM 121b functions as a memory area (work area) where a program or data read by the CPU 121a is temporarily stored.

The I/O port 121d is connected to the components described above such as the integrated gas system 20, the pressure sensor 245, the APC valve 243, the vacuum pump 246, the heater 207, the temperature sensor, the rotator 267 and the boat elevator 115.

The CPU 121a is configured to read the control program from the memory 121c and execute the control program read from the memory 121c. In addition, the CPU 121a is configured to read a recipe from the memory 121c in accordance with an operation command inputted from the input/output device 122. In accordance with the contents of the recipe read from the memory 121c, the CPU 121a may be configured to control various operations such as flow rate adjusting operations for various gases by the integrated gas system 20, opening and closing operations of valves (not shown) included in the integrated gas system 20, an opening and closing operation of the APC valve 243, a pressure adjusting operation by the APC valve 243 based on the pressure sensor 245, a temperature adjusting operation by the heater 207 based on the temperature sensor, a start and stop of the vacuum pump 246, an operation of adjusting a rotation and a rotation speed of the boat 217 by the rotator 267, an elevating and lowering operation of the boat 217 by the boat elevator 115 and an operation of transferring and accommodating the wafer 200 into the boat 217.

The controller 121 may be embodied by installing the above-mentioned program stored in an external memory 123 into the computer. For example, the external memory 123 may include a magnetic tape, a magnetic disk such as a flexible disk and a hard disk, an optical disk such as a CD and a DVD, a magneto-optical disk such as an MO and a semiconductor memory such as a USB memory and a memory card. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, and may refer to both of the memory 121c and the external memory 123. Instead of the external memory 123, a communication structure such as the Internet and a dedicated line may be used for providing the program to the computer.

### (2) Configuration of Source Material Collection System

As shown in FIG. 2, for example, the source material collection system 702 includes the exhaust pipe 231, a trap structure 706 and a heating structure 708.

The exhaust pipe 231 is a pipe through which the process gas containing a metal-containing source material is exhausted from the process chamber 201. For example, the exhaust pipe 231 includes a first exhaust line 711 and a second exhaust line 712.

The trap structure 706 is provided in the first exhaust line 711 and is a structure configured to collect the metal-containing source material from the process gas. A first automatic valve 721 and a first manual valve 731 (which serve as an example of a first valve) are provided in the first exhaust line 711 at an upstream side of the trap structure 706 of the first exhaust line 711. The first manual valve 731 is provided at a downstream side of the first automatic valve 721.

A second manual valve 732 and a second automatic valve 722 (which serve as an example of a second valve) are provided in the first exhaust line 711 at a downstream side of the trap structure 706 of the first exhaust line 711. The second manual valve 722 is provided at an upstream side of the second automatic valve 732.

A piping heater (not shown) may also be provided in the first exhaust line 711 of the piping.

The heating structure 708 is a structure configured to heat the trap structure 706 in accordance with a viscosity of the metal-containing source material. For example, the heating structure 708 is connected to a hot water circulator 734. The hot water (heat medium) generated by the hot water circulator 734 is supplied to the heating structure 708 and circulated. Thereby, it is possible to heat the trap structure 706 by the heating structure 708. The heating structure 708 may be configured as a mantle heater.

In addition, a cooling structure configured to cool the trap structure 706 may be provided. The cooling structure is configured to cool the process gas flowing into the trap structure 706. According to the present embodiments, a cold water circulator 736 is connected to the heating structure 708 in parallel with the hot water circulator 734. It is possible to use the heating structure 708 as the cooling structure by supplying the cold water (heat medium) generated by the cold water circulator 736 to the heating structure 708 and circulating the cold water. In other words, the heating structure 708 can also function as the cooling structure. According to the present embodiments, it is possible to heat or cool the trap structure 706 in a manner described above.

A cooling temperature is set to a temperature equal to or higher than a freezing temperature of the heat medium such that an equilibrium vapor pressure of a ruthenium (Ru) source material is approximately 90,000 Pa or less. At this time, when a partial pressure of the ruthenium source material in an exhaust gas is equal to or higher than the equilibrium vapor pressure, a coagulation may occur. In addition, the process gas entering the trap structure 706 is at a high temperature due to an adiabatic compression by the vacuum pump 246.

The heat medium flowing through the heating structure 708 may be supplied from a lower side toward an upper side of the trap structure 706. The same also applies when the heating structure 708 is used as the cooling structure. Thereby, it is possible to efficiently heat or cool the process gas.

Valves 741 and 742 are provided at an upstream side and a downstream of the hot water circulator 734 in a piping configured to connect the hot water circulator 734 and the heating structure 708, respectively. In addition, valves 751 and 752 are provided at an upstream side and a downstream of the cold water circulator 736 in a piping configured to connect the cold water circulator 736 and the heating structure 708, respectively. The valves 741 and 751 are provided in parallel with each other. The valves 742 and 752 are also provided in parallel with each other.

The trap structure 706 is configured such that the metal-containing source material does not undergo a phase change due to a heating by the heating structure 708. Thereby, it is possible to suppress re-sublimation of the source material, and it is also possible to increase a recovery efficiency.

The heating of the trap structure 706 by the heating structure 708 is configured to be adjusted such that the metal-containing source material can flow in the trap structure 706 in the direction of gravity by adjusting the viscosity of the metal-containing source material. Thereby, it is possible to increase the recovery efficiency of the metal-containing source material. In addition, a temperature of the heating structure 708 is set such that the viscosity of the metal-containing source material is equal to or lower than a predetermined viscosity and such that a vapor pressure of the metal-containing source material is equal to or lower than a predetermined pressure.

A viscosity of the ruthenium source material used as the metal-containing source material (metal-containing gas) may change significantly around a room temperature. For example, the viscosity changes from about 380 cP (at 25 °C) to about 90 cP (at 40 °C). The heating by the heating structure 708 is performed to set a temperature of the ruthenium source material to a temperature at which the viscosity of the ruthenium source material is adjusted about 100 cp or less such that the ruthenium source material can drip into a storage structure 710 by a flow of the process gas and the gravity. It is considered that droplets drip down a vertical plate.

The trap structure 706 may be heated not only during the recovery, but also periodically when a heat exchange efficiency is reduced due to an adhesion to a surface thereof.

A temperature control relate thereto may include: a method of controlling a temperature of the heat medium by assuming that the temperature of the heat medium and a temperature of a condensation surface of a trap are approximately the same; and a method of controlling a flow rate and the temperature of the heat medium such that a temperature of a sensor installed in the vicinity of the condensation surface becomes a pre-set temperature.

The source material collection system 702 may further include the vacuum pump 246. The vacuum pump 246 serves as an example of a pump which is installed at the exhaust pipe 231 between the process chamber 201 and the first exhaust line 711, for example, between a branching portion of the first exhaust line 711 and the second exhaust line 712, and is configured to vacuum-exhaust the process gas. In such a case, the trap structure 706 is disposed on a secondary side (exhaust side) of the vacuum pump 246. The vacuum pump 246 may be configured such that the inert gas is supplied thereto through a pipe 250 and a valve 252.

The second exhaust line 712 is provided in the exhaust pipe 231 to bypass the first exhaust line 711. The second exhaust line 712 is provided with a valve 714. The abatement apparatus 740 configured to detoxify the process gas flowing through the exhaust pipe 231 may be provided in the exhaust pipe 231 downstream of the trap structure 706, specifically, at the exhaust pipe 231 downstream of a confluent portion of the second exhaust line 712 and the first exhaust line. The second exhaust line 712 bypasses the trap structure 706 and connects the vacuum pump 246 to the abatement apparatus 740.

The entire piping from the vacuum pump 246 to the abatement apparatus 740 (specifically, an entirety of the piping from the vacuum pump 246 to the abatement apparatus 740 through the second exhaust line 712) may be heated by, for example, a piping heater 713.

The abatement apparatus 740 can render the process gas (which is exhausted to an atmospheric atmosphere) harmless. In addition, by using the second exhaust line 712 to bypass the trap structure 706 when the process gas is not supplied, it is possible to suppress the re-sublimation of the metal-containing source material repaired in the trap structure 706.

The source material collection system 702 may further include the storage structure 710 configured to recover the metal-containing source material. The storage structure 710 is connected to the trap structure 706 from below in the direction of gravity. In such a case, the metal-containing source material in the trap structure 706 is heated by the heating structure 708 and recovered in the storage structure 710. As a result, it is possible to efficiently recover the metal-containing source material.

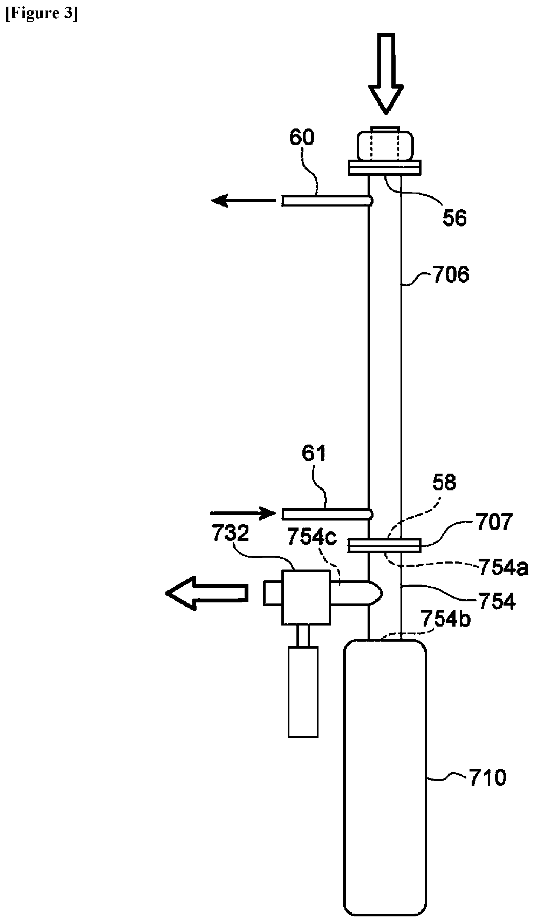

As shown in FIG. 3, the trap structure 706 and the storage structure 710 may be connected linearly by being connected to ports 754a and 754b of a T-branch pipe 754 facing each other. In such a case, the process gas is exhausted through a port 754c of the T-branch pipe 754, wherein the port 754c does not face the ports 754a and 754b. Thereby, it is possible to efficiently drip the metal-containing source material collected in the trap structure 706 into the storage structure 710 while efficiently exhausting the process gas.

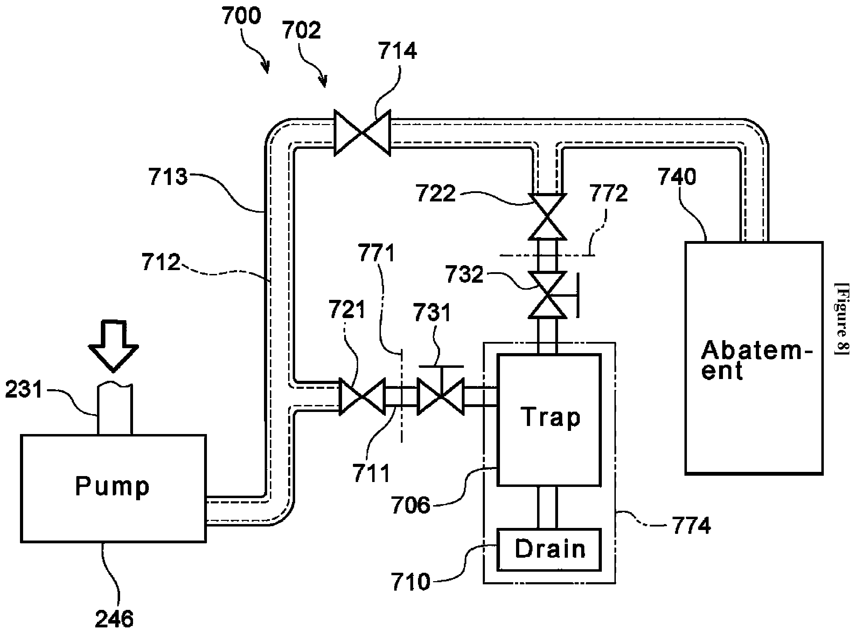

In addition, as shown in FIG. 8, the downstream side of the trap structure 706 in the first exhaust line 711 may be connected to the trap structure 706 without using the T-branch pipe 754.

A connecting structure 707 may be provided to connect the trap structure 706 and the storage structure 710. For example, the connecting structure 707 may be configured as a flange provided at a connection portion between an outlet 58 of the trap structure 706 and the port 754a of the T-branch pipe 754. The connecting structure 707 may be configured to suppress the adhesion of the metal-containing source material to a side wall of the storage structure 710.

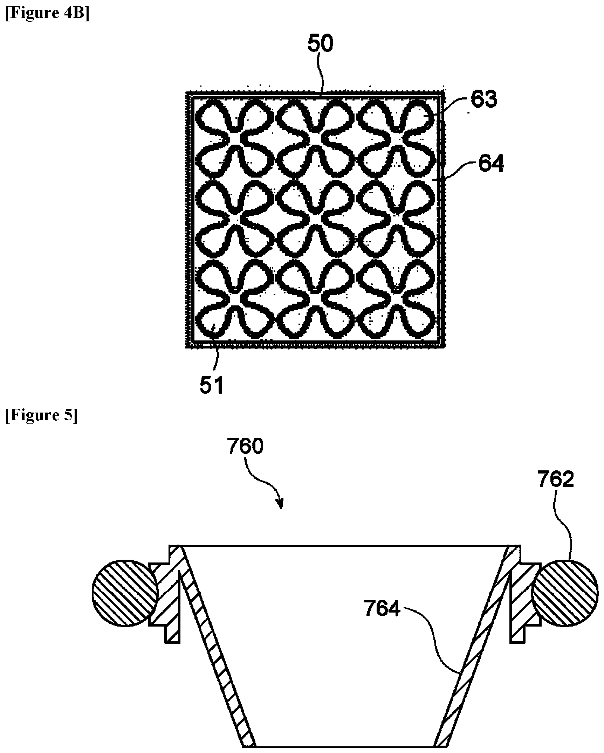

As an example, the connecting structure 707 may be provided with a guide structure 760 configured to direct the metal-containing source material toward a bottom of the storage structure 710 (see FIG. 5). For example, the guide structure 760 includes: a ring structure 762 attached to an inside (inner portion) of the connecting structure 707; and a funnel structure 764. The funnel structure 764 is engaged with an inner periphery of the ring structure 762, opens vertically up and down, and is provided to taper vertically from an upper portion toward a lower portion thereof. Thereby, it is possible to improve the recovery efficiency of the metal-containing source material.

An inlet 56 for the process gas is installed at an upper end of the trap structure 706, and the outlet 58 for the process gas is installed at a lower end of the trap structure 706. In addition, it is configured such that the process gas flows downward inside the trap structure 706 from the inlet 56 to the outlet 58. Thereby, it is possible to drip the metal-containing source material from the outlet 58 to the storage structure 710.

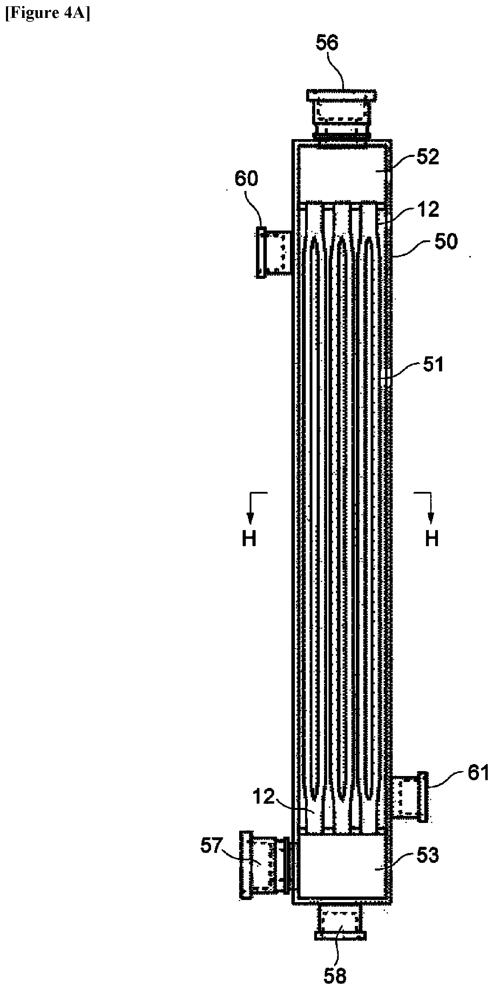

As described above, the trap structure 706 may be cooled by the refrigerant. In such a case, a gas-contacting surface in the trap structure 706 where a liquid of the metal-containing source material condenses may be a vertical surface. In FIG. 4A, for example, the trap structure 706 is provided with a heat transfer tube storage case 50. As shown in FIG. 4B, the heat transfer tube storage case 50 surrounds and accommodates a plurality of heat transfer tubes 51 which are regularly arranged in parallel with equal small intervals. For example, the heat transfer tubes 51 are arranged in a petal shape in a cross-section. In such an example, the heat transfer tube 51 is of a straight shape, but may be of a curved shape. The heat transfer tubes 51 are arranged such that any of grooves thereof face each other, except for those arranged on an outermost circumference thereof. By arranging the heat transfer tubes 51 in a manner described above, it is possible to bundle the heat transfer tubes 51 whose cross-sectional structures already described above with the highest density.

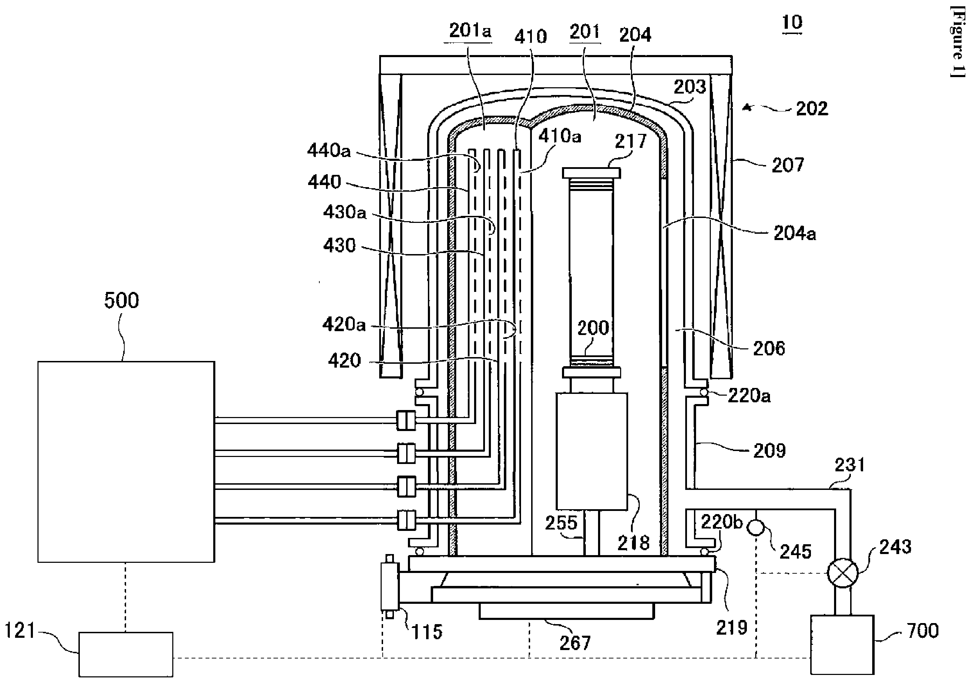

The heat transfer tube storage case 30 shown in the drawing is provided with connectors 36 and 37 configured to connect connection ends 12 of the plurality of heat transfer tubes together and configured to communicate with an inside 63 of the heat transfer tube. In addition, passages 64 with small intervals are provided between adjacent heat transfer tubes 51 and between the heat transfer tube storage case 50 and the heat transfer tube 51 adjacent to the heat transfer tube storage case 50. In such an example shown in the drawing, for example, the process gas is introduced into the connector (inlet side) 52 through the inlet 56, and then the process gas passes through the inside 63 of the heat transfer tube to the connector (outlet side) 53, and is discharged through the outlet 58. The metal-containing source material which is condensed is recovered in the storage structure 710, and the metal-containing source material which is not recovered is directed to the abatement apparatus 740 (FIG. 1). Meanwhile, for example, the heat medium is introduced from a heat medium inlet 61, passes through the passages 64, and is discharged through a heat medium outlet 60.

### (3) Substrate Processing (Substrate Processing Method)

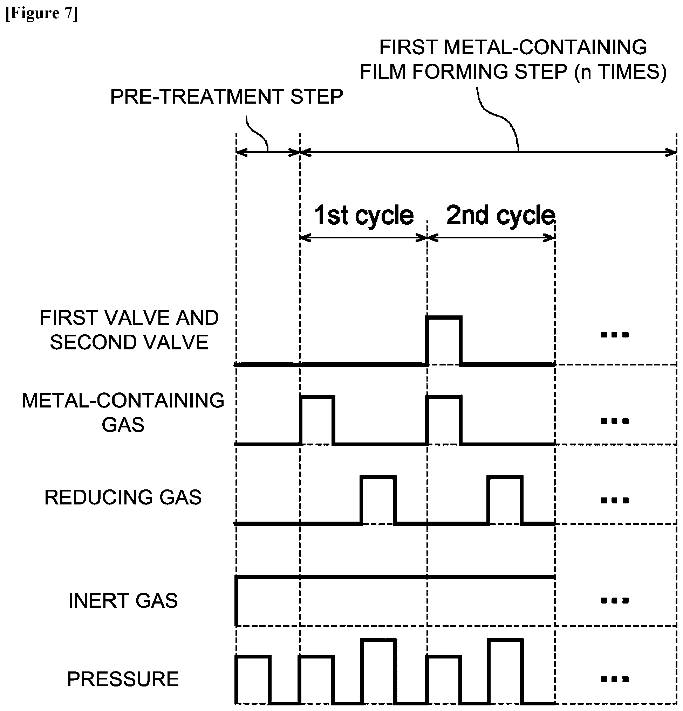

Hereinafter, as a part of a manufacturing process of the semiconductor device, an example of a substrate processing such as a step (film forming step) of forming a metal-containing film containing a metal element on the wafer 200 containing a metal element and serving as a base film (underlying film) is already formed on the wafer 200) will be described with reference to FIG. 7. The step of forming the metal-containing film on the wafer 200 on which the metal-containing film is already formed is performed using the process furnace 202 of the substrate processing apparatus 10 mentioned above. In the following description, operations of the components constituting the substrate processing apparatus 10 are controlled by the controller 121.

The substrate processing (manufacturing process of the semiconductor device) according to the present embodiments may include:
(a) a step of supplying the metal-containing gas containing the metal element to the wafer 200 on which the metal-containing film is formed;
(b) a step of supplying the reducing gas to the wafer 200;
(c) a step of supplying the oxygen-containing gas containing the oxygen atom and the reducing gas to the wafer 200; and
(d) a step of repeatedly performing a cycle including (a) and (b) a first number of times; and
(e) a step of repeatedly performing a cycle including (a) and (c) a second number of times after (d).

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". In the present specification, the terms "substrate" and "wafer" may be used as substantially the same meaning.

### <Wafer Loading Step>

The wafers 200 are charged (transferred) into the boat 217 (wafer charging step). After the boat 217 is charged with the wafers 200, as shown in FIG. 1, the boat 217 supporting the wafers 200 is elevated by the boat elevator 115 and loaded (transferred) into the process chamber 201 (boat loading step), and accommodated in the process vessel. In such a state, the seal cap 219 seals a lower end opening of the outer tube 203 via the O-ring 220.

### <Pressure Adjusting Step and Temperature Adjusting Step>

Then, the vacuum pump 246 vacuum-exhausts (decompresses and exhausts) the inner atmosphere of the process chamber 201 (that is, a space in which the wafers 200 are present (accommodated)) such that the inner pressure of the process chamber 201 reaches and is maintained at a desired pressure (vacuum degree). At this time, the inner pressure of the process chamber 201 is measured by the pressure sensor 245, and the APC valve 243 is feedback-controlled based on pressure information measured by the pressure sensor 245 (pressure adjusting step). The vacuum pump 246 continuously vacuum-exhausts the inner atmosphere of the process chamber 201 until at least a processing of the wafer 200 is completed.

In addition, the heater 207 heats the process chamber 201 such that the inner temperature of the process chamber 201 reaches and is maintained at a desired process temperature. At this time, an amount of the electric current supplied to the heater 207 is feedback-controlled based on the temperature information detected by the temperature sensor 263 such that the desired temperature distribution of the inner temperature of the process chamber 201 can be obtained (temperature adjusting step). The heater 207 continuously heats the process chamber 201 until at least the processing of the wafer 200 is completed.

According to the present embodiments, as the metal-containing film serving as the base film, for example, a film containing at least one among metal elements (which are transition metals (transition elements)) such as tungsten (W), molybdenum (Mo), copper (Cu) and cobalt (Co) may be used. The metal-containing film may be used as a metal wiring. The metal-containing film may be a metal wiring M1 in a lowermost layer among wiring layers, or may be a metal wiring My in a middle layer (y is a natural number).

For example, the metal-containing film is formed on the wafer 200, and an insulating film is formed on the metal-containing film. In addition, a recess (concave structure) such as a trench and a hole is formed in the insulating film of the wafer 200. When forming the metal-containing film containing the metal element and filling the recess, a metal oxide film serving as a natural oxide film may be formed on a surface of the metal-containing film. In particular, since the transition metal such as tungsten, molybdenum, copper and cobalt is easily oxidized, the natural oxide film is likely to be formed on the surface of the metal-containing film. When the natural oxide film is formed in the recess and remains without being removed, a contact resistance of the metal-containing film and the metal-containing film to be filled in the recess may increase. In addition, when a ruthenium (Ru) film is formed as the metal-containing film, for example, it is preferable to reduce the contact resistance in order to utilize low resistance characteristic of the ruthenium film.

Therefore, in the substrate processing (manufacturing process of the semiconductor device) according to the present embodiments, before forming the metal-containing film in the recess, a pre-treatment step is performed in the same process chamber 201, in which the halogen-containing gas containing the halogen element is supplied to the wafer 200 to remove at least a part of the metal oxide film. In other words, the pre-treatment step and a film forming step are performed consecutively in the same process chamber (in-situ). In other words, after the metal oxide film is removed by performing the pre-treatment step described below, the film forming step described below is performed in the process chamber 201 (where the pre-treatment step is also performed) to form the metal-containing film.

### A. Pre-treatment Step

### <Halogen-containing Gas Supply Step S1>

Reference numerals related to the steps are not shown (omitted) in the drawings. The valve 344 is opened to supply the halogen-containing gas into the gas supply pipe 340. After a flow rate of the halogen-containing gas is adjusted by the MFC 342, the halogen-containing gas whose flow rate is adjusted is supplied into the process chamber 201 through the gas supply holes 440a of the nozzle 440, and is exhausted through the exhaust pipe 231. Thereby, the halogen-containing gas is supplied onto the wafer 200. In the present step, in parallel with a supply of the halogen-containing gas, the valve 544 is opened to supply the inert gas into the gas supply pipe 540. After a flow rate of the inert gas supplied into the gas supply pipe 540 is adjusted by the MFC 542, the inert gas whose flow rate is adjusted is supplied into the process chamber 201 together with the halogen-containing gas, and is exhausted through the exhaust pipe 231. In addition, in order to prevent the halogen-containing gas from entering the nozzles 410, 420 and 430, the valves 514, 524 and 534 are opened to supply the inert gas into the gas supply pipes 510, 520 and 530. Then, the inert gas is supplied into the process chamber 201 through the gas supply pipes 310, 320 and 330 and the nozzles 410, 420 and 430, and is exhausted through the exhaust pipe 231.

In the present step, for example, the APC valve 243 is appropriately adjusted such that the inner pressure of the process chamber 201 can be set to a pressure within a range from 1 Pa to 3,990 Pa. For example, a supply flow rate of the halogen-containing gas controlled by the MFC 342 can be set to a flow rate within a range from 0.05 slm to 20 slm. For example, each supply flow rate of the inert gas controlled by each of the MFCs 512, 522, 532 and 542 can be set to a flow rate within a range from 0.1 slm to 50 slm. In the present specification, a notation of a numerical range such as "from 1 Pa to 3,990 Pa" means that a lower limit and an upper limit thereof are included in the numerical range. Therefore, for example, the numerical range "from 1 Pa to 3,990 Pa" means a range equal to or higher than 1 Pa and equal to or lower than 3,990 Pa. The same also applies to other numerical ranges described herein.

In the present step, the halogen-containing gas and the inert gas are supplied into the process chamber 201 without supplying other gases into the process chamber 201. A substitution reaction occurs between the halogen-containing gas and at least a part of the metal oxide film formed on the metal-containing film. That is, oxygen (O) in the metal oxide film reacts with the halogen element contained in the halogen-containing gas so as to be desorbed from the metal oxide film, and is discharged (exhausted) from the process chamber 201 as reaction by-products. That is, at least a part of the metal oxide film is removed (etched).

As the halogen-containing gas, for example, a gas capable of selectively etching the metal oxide film may be used. As the halogen-containing gas, for example, a gas containing one or more chlorine atoms and one or more oxygen atoms may be used. That is, as the chlorine-containing gas, for example, an oxyhalide whose molecular structure is MOₓCl_{y} may be used. In the formula shown above, for example, M may contain one or more elements among phosphorus (P), sulfur (S) and carbon (C). As the oxyhalide, for example, a gas such as phosphorus oxychloride (POCl₃) gas, thionyl chloride (SOCl₂) gas and carbonyl dichloride (COCl₂) gas may be used. As the halogen-containing gas, for example, one or more of the gases exemplified above may be used.

When the oxyhalide is used as the halogen-containing gas as described above, oxygen in the metal oxide film reacts with chlorine (Cl) or oxygen, and is desorbed from the metal oxide film. Thereby, it is possible to selectively etch the metal oxide film alone. For example, it is possible to selectively etch the metal oxide film alone without etching the insulating film formed of a silicon oxide (SiO₂) film. In other words, the halogen-containing gas may also be referred to as an "etching gas" capable of etching the metal oxide film.

### < Residual Gas Removing (Exhausting) Step S2>

After a predetermined time has elapsed since the supply of the halogen-containing gas is started, for example, 1 second to 600 seconds, the supply of the halogen-containing gas from the gas supply pipe 340 is stopped. That is, for example, a supply time of supplying the halogen-containing gas to the wafer 200 is set to 1 second to 600 seconds. In the present step, with the APC valve 243 of the exhaust pipe 231 open, the vacuum pump 246 vacuum-exhausts the inner atmosphere of the process chamber 201. Thereby, it is possible to remove a substance (residual gas) such as the halogen-containing gas (which remains unreacted or which contributed to an etching of the metal oxide film) from the process chamber 201. That is, the space in which the wafers 200 are present is exhausted. In other words, the process chamber 201 is purged. In the present step, the inert gas is continuously supplied into the process chamber 201. The inert gas acts as a purge gas, which improves an efficiency of removing the halogen-containing gas (which remains unreacted or which contributed to the etching of the metal oxide film) remaining in the process chamber 201 out of the process chamber 201.

In addition, the pre-treatment step described above may also be referred to as a "metal oxide film removing step", a "pre-etching step" or a "pre-cleaning step".

### B. Metal-containing Film Forming Step (Film Forming Step)

### <First Metal-containing Film Forming Step>

### <Metal-containing Gas Supply Step S11>

The metal-containing gas serving as the source gas is supplied from the integrated gas system 20 into the gas supply pipe 310. After a flow rate of the metal-containing gas is adjusted by the integrated gas system 20, the metal-containing gas whose flow rate is adjusted is supplied into the process chamber 201 through the gas supply holes 410a of the nozzle 410, and is exhausted through the exhaust pipe 231. In the present step, in parallel with a supply of the metal-containing gas, the inert gas is supplied from the integrated gas system 20 into the gas supply pipe 310. After a flow rate of the inert gas is adjusted by the integrated gas system 20, the inert gas whose flow rate is adjusted is supplied into the process chamber 201 together with the metal-containing gas, and is exhausted through the exhaust pipe 231. In addition, in order to prevent the metal-containing gas from entering the nozzles 420, 430 and 440, the inert gas is supplied from the integrated gas system 20. Then, the inert gas is supplied into the process chamber 201 through the gas supply pipes 320, 330 and 340 and the nozzles 420, 430 and 440, and is exhausted through the exhaust pipe 231.

In the present step, for example, the integrated gas system 20 is appropriately operated such that the inner pressure of the process chamber 201 can be set to a pressure within a range from 1 Pa to 3,990 Pa. For example, a supply flow rate of the metal-containing gas can be set to a flow rate within a range from 0.05 slm to 1 slm. For example, each supply flow rate of the inert gas can be set to a flow rate within a range from 0.1 slm to 50 slm.

In the present step, the metal-containing gas and the inert gas are supplied into the process chamber 201 without supplying other gases into the process chamber 201. That is, by supplying the metal-containing gas to the wafer 200 from which the metal oxide film is removed, a metal-containing layer is formed on the wafer 200 (that is, on the insulating film and in the recess on the surface of the wafer 200). The metal-containing layer may be a metal layer containing other elements, or may be an adsorption layer of the metal-containing gas.

As the metal-containing gas, for example, a gas containing a metal element serving as the transition metal (transition element) may be used. Preferably, as the metal-containing gas, for example, a gas containing a platinum group element serving as a Group 8 element may be used. As the metal-containing gas, for example, a ruthenium-containing gas containing ruthenium (Ru) may be used. In a manner described above, by using the gas containing the transition metal (the platinum group element serving as the Group 8 element), it is possible to form a metal-containing film whose resistance is low. In addition, as the metal-containing gas, for example, a gas containing the metal element and a carbonyl group may be used. Thereby, it is possible to improve a film forming rate.

As the metal-containing gas, for example, a gas obtained by vaporizing an organometallic material such as bisethylcyclopentadienyl ruthenium (Ru(C₂H₅C₅H₄)₂), butyl ruthenocene (Ru(C₅H₅)(C₄H₉C₅H₄)), tris-2,4-octanedionato ruthenium (Ru[CH₃COCHCO(CH₂)₃CH₃]₃), 2,4-dimethylpentadienylethylcyclopentadienyl ruthenium (Ru(C₂H₅C₅H₄)((CH₃)C₅H₅)), Ru(C₇H₈)(C₇H₁₁O₂), dicarbonylbis(5-methyl-2,4-hexanediketonate)ruthenium(II) (C₁₆H₂₂O₆Ru), triruthenium dodecacarbonyl (Ru₃(CO)₁₂), η4-2,3-dimethylbutadiene ruthenium tricarbonyl ((DMBD)Ru(CO)₃), η4-butadieneruthenium tricarbonyl ((BD)Ru(CO₃)), η4-1,3-cyclohexadienyl ruthenium tricarbonyl ((CHD)Ru(CO)₃), bis(cyclopentadienylruthenium) dicarbonyl (C₁₄H₁₀O₄Ru₂) and tricarbonyldichloro ruthenium(II) ((Ru(CO)₃Cl₂)₂) may be used. As the metal-containing gas, for example, one or more of the gases exemplified above may be used.

In the present step, for example, when the ruthenium-containing gas is used as the metal-containing gas, a ruthenium-containing layer is formed in the recess on the wafer 200. The ruthenium-containing layer may be a ruthenium layer containing other elements, may be an adsorption layer of the ruthenium-containing gas, or may contain both of the ruthenium layer and the adsorption layer of the ruthenium-containing gas.

### < Residual Gas Removing Step S12>

After a predetermined time has elapsed since the supply of the metal-containing gas is started, for example, 1 second to 120 seconds, the supply of the metal-containing gas from the gas supply pipe 310 is stopped. That is, for example, a supply time of supplying the metal-containing gas to the wafer 200 is set to 1 second to 120 seconds. In the present step, with the APC valve 243 of the exhaust pipe 231 open, the vacuum pump 246 vacuum-exhausts the inner atmosphere of the process chamber 201. Thereby, it is possible to remove a substance (residual gas) such as the metal-containing gas (which remains unreacted or which contributed to a formation of the metal-containing layer) from the process chamber 201. In other words, the process chamber 201 is purged. In the present step, the inert gas is continuously supplied into the process chamber 201. The inert gas acts as the purge gas, which improves an efficiency of removing the metal-containing gas (which remains unreacted or which contributed to the formation of the metal-containing layer) remaining in the process chamber 201 out of the process chamber 201.

### <Reducing Gas Supply Step S13>

After the residual gas in the process chamber 201 is removed, the reducing gas is supplied from the integrated gas system 20 into the gas supply pipe 320. After a flow rate of the reducing gas is adjusted by the integrated gas system 20, the reducing gas whose flow rate is adjusted is supplied into the process chamber 201 through the gas supply holes 420a of the nozzle 420, and is exhausted through the exhaust pipe 231. Thereby, the reducing gas is supplied onto the wafer 200. In the present step, in parallel with a supply of the reducing gas, the inert gas is supplied from the integrated gas system 20 into the gas supply pipe 320. After a flow rate of the inert gas is adjusted by the integrated gas system 20, the inert gas whose flow rate is adjusted is supplied into the process chamber 201 together with the reducing gas, and is exhausted through the exhaust pipe 231. In addition, in order to prevent the reducing gas from entering the nozzles 410, 430 and 440, the inert gas is supplied from the integrated gas system 20. Then, the inert gas is supplied into the process chamber 201 through the gas supply pipes 310, 330 and 340 and the nozzles 410, 430 and 440, and is exhausted through the exhaust pipe 231.

In the present step, for example, the integrated gas system 20 is appropriately operated such that the inner pressure of the process chamber 201 can be set to a pressure within a range from 5 Pa to 15,000 Pa. For example, a supply flow rate of the reducing gas can be set to a flow rate within a range from 15 slm to 50 slm. For example, each supply flow rate of the inert gas can be set to a flow rate within a range from 0.1 slm to 50 slm.

Here, a pressure (total pressure) of the space in which the wafers 200 are present (that is, the inner pressure of the process chamber 201) in the present step is set to be higher than a pressure (total pressure) of the space in which the wafers 200 are present in the step S23 described later. That is, the inner pressure of the process chamber 201 in the present step is set to be higher than the inner pressure of the process chamber 201 in the step S23 described later.

**In** addition, by increasing the inner pressure of the process chamber 201 when the reducing gas is supplied, it is possible to easily remove a ligand in the film. However, when the purge is performed at a high pressure when removing the residual gas in the step S12 mentioned above so as to remove the ligand, it may take a long time to return the inner pressure of the process chamber 201 to an original pressure thereof. **In** the present step, by increasing the inner pressure of the process chamber 201 when the reducing gas is supplied, it is possible to obtain an effect of removing (purging) the ligand in a shorter time as compared with a case where the inner pressure of the process chamber 201 is increased during the purge.

**In** addition, when the inner pressure of the process chamber 201 is set to be high during the supply of the reducing gas in the entirety of the substrate processing, it takes a time to adjust the pressure from a low pressure to a high pressure between the supply of the metal-containing gas and the supply of the reducing gas. In the present disclosure, in the entirety of the substrate processing, by setting the inner pressure of the process chamber 201 to the high pressure in the early runs of supplying the reducing gas in the first metal-containing film forming step and by setting the inner pressure of the process chamber 201 to the low pressure in the later runs of supplying the reducing gas in the first metal-containing film forming step, it is possible to shorten the time to adjust the pressure from the low pressure to the high pressure between the supply of the metal-containing gas and the supply of the reducing gas. In other words, it is possible to improve the productivity.

In addition, a partial pressure of the reducing gas in the present step may be set to be higher that the partial pressure of the reducing gas in the step S23 described later. In addition, at least one among the inner pressure of the process chamber 201 and the partial pressure of the reducing gas in the present step may be changed every several cycles (first number of times) thereof. In other words, at least one among the inner pressure of the process chamber 201 and the partial pressure of the reducing gas when the reducing gas is supplied in the present step may be changed every several cycles (first number of times) of the first metal-containing film forming step is repeatedly performed. Specifically, at least one among the inner pressure of the process chamber 201 and the partial pressure of the reducing gas in the present step may be decreased each several cycle (first number of times).

In the present step, the reducing gas and the inert gas are supplied into the process chamber 201 without supplying other gases into the process chamber 201.

As the reducing gas, for example, a gas such as a hydrogen-containing gas may be used. As the hydrogen-containing gas, for example, a gas such as hydrogen (H₂) gas, deuterium (D₂) gas and a gas containing activated hydrogen may be used. As the reducing gas, for example, one or more of the gases exemplified above may be used.

In the present embodiments, for example, when the H₂ gas is used as the reducing gas, a substitution reaction occurs between the H₂ gas and at least a part of the metal-containing layer formed on the wafer 200 in the step S11. For example, when the gas containing the metal element and the carbonyl group is used as the metal-containing gas, a substance such as oxygen in the metal-containing layer reacts with H₂ so as to be desorbed from the metal-containing layer, and is discharged (exhausted) from the process chamber 201 as reaction by-products such as water vapor (H₂O). Thereby, the metal-containing layer (which contains the metal element) in which oxygen is reduced is formed on the wafer 200.

### < Residual Gas Removing Step S14>

After the metal-containing layer in which oxygen is reduced is formed, the supply of the reducing gas is stopped. Then, by process procedures similar to those of the step S12 described above, a substance (residual gas) such as the reducing gas (which remains unreacted or which contributed to a formation of the metal-containing layer) and the reaction by-products is removed from the process chamber 201. In other words, the process chamber 201 is purged.

### <Performing Predetermined Number of Times>

By performing a cycle (in which the steps S11 to S14 described above are sequentially performed in this order) at least once (a first number of times (a predetermined number of times) (n times, n is an integer of 1 or more)), it is possible to form the first metal-containing film of a predetermined thickness on the wafer. It is preferable that the cycle described above is performed a plurality number of times. Thereby, it is possible to form the first metal-containing film in which an amount of a surface oxide layer of the metal-containing film is reduced and in which a growth of an oxide layer at an interface is suppressed.

### <After-purge Step and Returning to Atmospheric Pressure Step>

Then, the inert gas is supplied into the process chamber 201 through each of the gas supply pipes 510 to 540, and is exhausted through the exhaust pipe 231. The inert gas acts as the purge gas. Thereby, the inner atmosphere of the process chamber 201 is purged with the inert gas. As a result, the gas remaining in the process chamber 201 and the reaction by-products remaining in the process chamber 201 are removed from the process chamber 201 (after-purge step). Thereafter, the inner atmosphere of the process chamber 201 is replaced with the inert gas (substitution by the inert gas), and the inner pressure of the process chamber 201 is returned to the normal pressure (returning to atmospheric pressure step).

### <Wafer Discharging Step>

Thereafter, the cap 219 is lowered by the boat elevator 115 and the lower end of the outer tube 203 is opened. The boat 217 with the wafers 200 (which are processed) charged therein is unloaded out of the outer tube 203 through the lower end of the outer tube 203 (boat unloading step). Then, the wafers 200 (which are processed) are discharged (transferred) out of the boat 217 (wafer discharging step).

That is, in the substrate processing of the present disclosure, by performing the first metal-containing film forming step, the first metal-containing film in which the growth of the oxide layer at the interface is suppressed can be formed on the wafer 200 where the metal-containing film is already formed on the surface thereof.

### <Source Material Collection Method>

According to the present embodiments, a source material collection method (FIGS. 1 and 2) may include:
a step of exhausting the process gas containing the metal-containing source material from the process chamber 201 through the exhaust pipe 231;
a step of collecting the metal-containing source material from the process gas by the trap structure 706 provided in the first exhaust line 711 constituting the exhaust pipe 231; and
a step of heating the trap structure 706 by the heating structure 708 in accordance with the viscosity of the metal-containing source material and dripping the metal-containing source material in the trap structure 706 out of the trap structure 706.

The process gas exhausted from the process chamber 201 is sucked into the vacuum pump 246 in FIG. 2, and flows into the exhaust system 700. In such an operation, by closing the valve 714 and opening the first automatic valve 721, the first manual valve 731, the second manual valve 732 and the second automatic valve 722, the process gas is introduced into the trap structure 706, and the metal-containing source material is collected. The valves mentioned above are open during the supply of the metal-containing gas (that is, the process gas containing the metal-containing source material) in FIG. 7. In such an operation, for example, by using the hot water circulator 734, the trap structure 706 is heated by the heating structure 708 in accordance with the viscosity of the metal-containing source material, and the metal-containing source material in the trap structure 706 is dripped out, for example, into the storage structure 710.

When the guide structure 760 shown in FIG. 5 is provided inside the connecting structure 707 shown in FIG. 3, it is possible to direct the metal-containing source material collected in the trap structure 706 toward the bottom of the storage structure 710. Thereby, it is possible to prevent the metal-containing source material from adhering to an inner wall of the storage structure 710, and it is also possible to efficiently recover the liquid dripping from the trap structure 706.

According to the present embodiments, the source material is recovered in a state without being decomposed. As a result, it is possible to reduce the cost and energy consumption during re-refining.

When recovering the metal-containing source material in the trap structure 706, the trap structure 706 may be cooled using the cold water circulator 736 to minimize the re-sublimation of the source material. By cooling the trap structure 706, it is possible to condense, liquefy and collect the metal-containing source material.

The process gas passed through the trap structure 706 passes through a T-branch pipe 709 and is detoxified in the abatement apparatus 740, and then is exhausted to the atmospheric atmosphere.

When the source material is not being recovered, the process gas is not supplied to the trap structure 706 to prevent the re-sublimation of the metal-containing source material collected in the trap structure 706. Specifically, by closing the first automatic valve 721 and the second automatic valve 722 and opening the valve 714, it is possible to switch an exhaust path of the process gas to the second exhaust line 712. As a result, the process gas flows to the abatement apparatus 740 without passing through the trap structure 706.

When cleaning the process furnace 202, the metal-containing source material (precious metal) adhering to the inside of the process chamber 201 is recovered. In addition, the cleaning gas is not supplied to the trap structure 706 to prevent the metal-containing source material recovered as described above from decomposing.

When performing a maintenance operation, the trap structure 706 may be lightly heated for a short time such that the metal-containing source material collected by the trap structure 706 can be accumulated in the storage structure 710.

In addition, a component such as the first automatic valve 721 of the source material collection system 702 is not limited to that switched in accordance with to as a type of each gas within a cycle of supplying the process gas. For example, the process gas may always pass through the trap structure 706 during the film forming step, and at least an exhaust of the cleaning gas may bypass the trap structure 706.

### <Replacement of Trap Structure and Storage Structure>

As shown in an example in FIG. 8, the trap structure 706 may be configured to be capable of being detached from the first exhaust line 711 by closing the first valve and the second valve.

A first detachable structure 771 may be provided between the first automatic valve 721 and the first manual valve 731, and a second detachable structure 772 may be provided between the second automatic valve 722 and the second manual valve 732.

For example, a replacement procedure for the trap structure 706 and the storage structure 710 is as follows.
1. The first exhaust line is filled with the inert gas (that is, purged). With the trap structure 706 in communication with the abatement apparatus 740, the inert gas is injected directly into a ballast port (pipe 250) of the vacuum pump 246 or the first exhaust line 711. The first automatic valve 721 and the second automatic valve 722 are closed, and with the trap structure 706 sealed with the inert gas at approximately the atmospheric pressure, the trap structure 706 is heated for a predetermined time. In addition, when there is a possibility that the pressure may be elevated above the atmospheric pressure due to the heating, the trap structure 706 may not be sealed.
2. The trap structure 706 is switched to a cooling. In addition, such an operation may be omitted.
3. The cooling is stopped, and a cooling water piping is removed from the trap structure 706. The cooling water piping is a piping configured to connect the heating structure 708 and the cold water circulator 736 in FIG. 1.
4. A simple glove box 774 is installed around the trap structure 706 and the storage structure 710 which are already installed.
5. After purging the first exhaust line 711 again with the inert gas, the first automatic valves 721 (AV261, 262) are closed. In addition, such an operation may be omitted.
6. The first manual valve 731 and the second manual valve 732 are closed.
7. A flange connection between the trap structure 706 and the first exhaust line 711 and a flange connection between the T-branch pipe 754 and the first exhaust line 711 are released, and the trap structure 706 and the storage structure 710 are removed from the first exhaust line 711 as shown in FIG. 3.
8. The flanges of the trap structure 706 and the storage structure 710 (which are removed as describe above) are protected by blocking them with structures such as blank flanges (not shown). In addition, by cleaning the trap structure 706 and the storage structure 710 (which are removed as describe above), the metal-containing source material is recovered.
9. A new trap structure 706 and a new storage structure 710 are connected to the first exhaust line 711.
10. The cooling water piping is connected again to the trap structure 706.

In a manner described above, by removing the trap structure 706 and the storage structure 710 from the first exhaust line 711, it is possible to easily recover the source material recovered in the storage structure 710 and the source material remaining in the trap structure 706 without dripping into the storage structure 710. In addition, since no valve is provided between the trap structure 706 and the storage structure 710, it is possible to prevent (suppress) the liquid of the source material liquid condensed in the trap structure 706 from accumulating in the valve.

### <Modified Example>

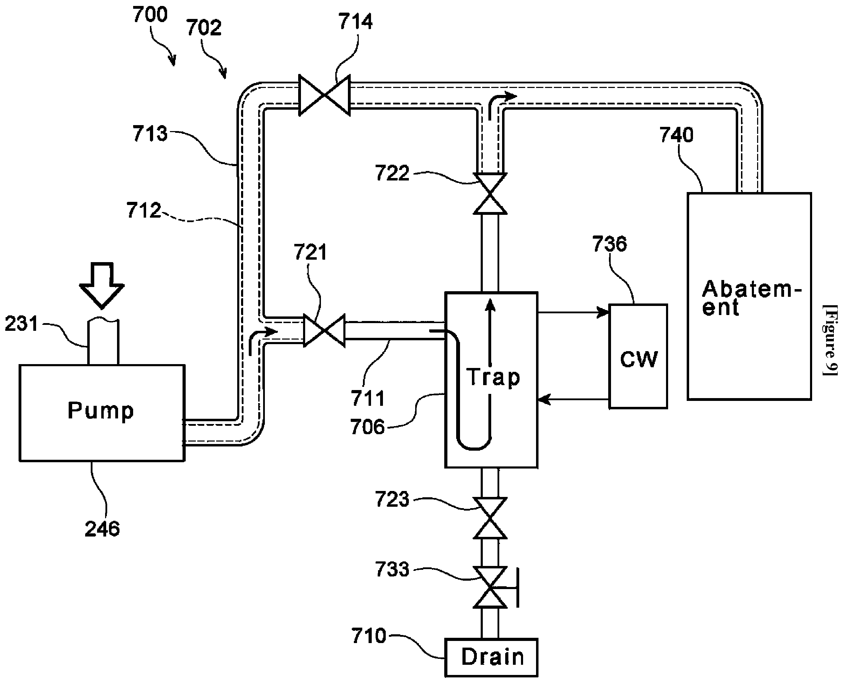

In the example shown in FIG. 2, the first exhaust line 711 is provided with the first manual valve 731 and the second manual valve 732. However, according to the present modified example shown in FIG. 9, such manual valves are not provided. According to the present modified example, a third automatic valve 723 and a third manual valve 733 are provided between the trap structure 706 and the storage structure 710.

In the present modified example, a start and stop of the recovery of the metal-containing source material repaired in the trap structure 706 toward the storage structure 710 can be switched by opening and closing the third automatic valve 723 and the third manual valve 733.

### <Substrate Processing Apparatus>

The substrate processing apparatus 10 may include:
the process chamber 201 in which the substrate disposed therein is processed;
the metal-containing gas supplier configured to supply the process gas containing the metal-containing source material into the process chamber 201; and
the source material collection system 702 configured to collect the metal-containing source material from the process gas exhausted from the process chamber 201 by the vacuum pump 246.

In addition, the source material collection system 702 may include:
the exhaust pipe 231 through which the process gas exhausted is guided;
the trap structure 706 provided in the first exhaust line 711 constituting the exhaust pipe 231 and configured to recover the metal-containing source material from the process gas; and
the heating structure 708 configured to heat the trap structure 706 in accordance with the viscosity of the metal-containing source material.

### <Method of Manufacturing Semiconductor Device>

The method of manufacturing the semiconductor device may include:
a step of forming the film containing the metal element on the substrate in the process chamber 201 by supplying a gaseous metal-containing source material containing the metal element into the process chamber 201;
the step of exhausting the process gas containing the metal-containing source material from the process chamber 201 through the exhaust pipe 231;
the step of collecting the metal-containing source material from the process gas by the trap structure 706 provided in the first exhaust line 711 constituting the exhaust pipe 231; and
the step of heating the trap structure 706 by the heating structure 708 in accordance with the viscosity of the metal-containing source material and dripping the metal-containing source material in the trap structure 706 out of the trap structure 706.

### (5) Effects According to Present Embodiments

According to the substrate processing apparatus 10 of the present embodiments, it is possible to obtain one or more of the following effects.
(a) By performing the first metal-containing film forming step, it is possible to form the metal-containing film in which the growth of the oxide layer at the interface is suppressed.
(b) By optimizing the number of cycles (thickness of the first metal-containing film) in the first metal-containing film forming step, it is possible to form the metal-containing film in which both of the suppression of the oxide layer and the reduction of impurities are improved.
(d) By performing a pre-treatment step before the film forming step, it is possible to reduce the contact resistance between the metal-containing film and the metal-containing film to be filled in the recess.
(e) It is possible to efficiently recover the collected source material without vaporizing or deteriorating.
(f) An exhaust speed (exhaust rate) is not reduced by the trap structure 706. In addition, it is possible to configure the trap structure 706 with light weight.
(g) By additionally using the flow of the exhaust gas, it is possible to drip the liquid collected by the trap structure 706 into the storage structure 710 below the trap structure 706.
(h) Because the flow of the exhaust gas and a heat exchange plate (that is, the gas-contacting surface) are parallel, it is possible to reduce the conductance, to configure the trap structure 706 with thin (compact) and lightweight, and to easily perform the installation and the replacement. Because the heat exchange plate is provided vertically, the droplets are most likely to flow down.

### (6) Other Embodiments of Present Disclosure

The technique of the present disclosure is described in detail by way of the embodiments mentioned above. However, the technique of the present disclosure is not limited thereto. The technique of the present disclosure may be modified in various ways without departing from the scope thereof. In addition, in the following description of the modified examples, features different from those of the embodiments mentioned above will be mainly described in detail.

For example, the embodiments mentioned above are described by way of an example in which a predetermined film is formed on the wafer 200. However, the technique of the present disclosure is not limited to a particular type of the film.

For example, the embodiments mentioned above are described by way of an example in which the substrate processing apparatus (that is, a batch and vertical type apparatus) capable of simultaneously processing a plurality of substrates is used to form the film. However, the technique of the present disclosure is not limited thereto. For example, the technique of the present disclosure may be preferably applied when a single wafer type substrate processing apparatus capable of processing one or several substrates at once is used to form the film.

It is preferable that the recipe (that is, a program defining parameters such as the process procedures and the process conditions of the substrate processing) used to perform the substrate processing is prepared individually in accordance with contents of the substrate processing such as a type of the film to be formed, a composition ratio of the film, a quality of the film, a thickness of the film, the process procedures and the process conditions of the substrate processing. For example, it is preferable that a plurality of recipes are stored (installed) in the memory 121c in advance via an electric communication line or the external memory 123. Then, when starting the substrate processing, the CPU 121a preferably selects the appropriate recipe among the recipes stored in the memory 121c in accordance with the contents of the substrate processing. With such a configuration, various films of different types, different composition ratios, different qualities and different thicknesses can be formed with a high reproducibility using a single substrate processing apparatus. In addition, since a burden on an operator such as inputting the process procedures and the process conditions can be reduced, various processes (that is, the substrate processing) can be performed quickly while avoiding a misoperation of the substrate processing apparatus 10.

The process recipe (recipe) described above is not limited to creating a new recipe. For example, the recipe may be prepared by changing an existing recipe installed in the substrate processing apparatus in advance. When changing the existing recipe to the new recipe, the new recipe may be installed in the substrate processing apparatus via the electric communication line or the recording medium in which the new recipe is stored. For example, the existing recipe already installed in the substrate processing apparatus may be directly changed to the new recipe by operating the input/output device 122 of the substrate processing apparatus.

In the present specification, the term "temperature" may refer to the "temperature of the wafer 200" or the "inner temperature of the process chamber 201", and the term "pressure" may refer to the inner pressure of the process chamber 201. In addition, the term "process time" refers to a time duration of continuously performing a process related thereto.

For example, the embodiments mentioned above are described by way of an example in which a substrate processing apparatus including a cold wall type process furnace is used to form the film. However, the technique of the present disclosure is not limited thereto. For example, the technique of the present disclosure may be preferably applied when a substrate processing apparatus including a hot wall type process furnace is used to form the film.

## Claims

1. A source material collection system comprising:
an exhaust pipe through which a process gas containing a metal-containing source material is exhausted from a process chamber, wherein the exhaust pipe comprises a first exhaust line;
a trap structure provided in the first exhaust line and configured to collect the metal-containing source material from the process gas; and
a heating structure configured to heat the trap structure in accordance with a viscosity of the metal-containing source material.

2. The source material collection system of claim 1, further comprising
a storage structure configured to recover the metal-containing source material,
wherein the metal-containing source material in the trap structure is heated by the heating structure and recovered in the storage structure.

3. The source material collection system of claim 1, further comprising
a pump provided in the exhaust pipe between the process chamber and the first exhaust line and configured to vacuum-exhaust the process gas,
wherein the trap structure is disposed on a secondary side of the pump.

4. The source material collection system of claim 1, wherein the trap structure is configured such that the metal-containing source material does not undergo a phase change due to a heating by the heating structure.

5. The source material collection system of claim 1, further comprising
a cooling structure configured to cool the trap structure,
wherein the cooling structure is further configured to cool the process gas flowing into the trap structure.

6. The source material collection system of claim 2, further comprising
a connecting structure configured to connect the trap structure and the storage structure,
wherein the connecting structure is further configured to suppress an adhesion of the metal-containing source material to a side wall of the storage structure.

7. The source material collection system of claim 6, wherein the trap structure is provided with a guide structure configured to direct the metal-containing source material toward a bottom of the storage structure.

8. The source material collection system of claim 1, wherein a heating of the trap structure by the heating structure is to be adjusted such that the metal-containing source material is capable of flowing in the trap structure in a direction of gravity by adjusting the viscosity of the metal-containing source material.

9. The source material collection system of claim 1, further comprising:
a first valve provided in the first exhaust line at an upstream side of the trap structure; and
a second valve provided in the first exhaust line at a downstream side of the trap structure,
wherein the trap structure is configured to be capable of being detached from the first exhaust line by closing the first valve and the second valve.

10. The source material collection system of claim 1, wherein a heat medium flowing through the heating structure is to be supplied from a lower side toward an upper side of the trap structure.

11. The source material collection system of claim 5, wherein a heat medium flowing through the cooling structure is to be supplied from a lower side toward an upper side of the trap structure.

12. The source material collection system of claim 3, further comprising
an abatement apparatus provided in the exhaust pipe downstream of the trap structure and configured to detoxify the process gas,
wherein the exhaust pipe from the pump to the abatement apparatus is configured to be capable of being heated.

13. The source material collection system of claim 3, further comprising
a second exhaust line provided in the exhaust pipe to bypass the first exhaust line; and
an abatement apparatus configured to detoxify the process gas flowing through the exhaust pipe,
wherein an entire piping from the pump to the abatement apparatus through the second exhaust line is configured to be capable of being heated.

14. The source material collection system of claim 2, wherein the trap structure and the storage structure are connected linearly by being connected to ports of a T-branch pipe facing each other,
wherein the process gas is exhausted through a port of the T-branch pipe, and
wherein the port of the T-branch pipe does not face the ports of the T-branch pipe.

15. The source material collection system of claim 9, further comprising a first detachable structure and a second detachable structure,
wherein the first valve comprises a first automatic valve and a first manual valve provided downstream of the first automatic valve,
the second valve comprises a second automatic valve and a second manual valve provided upstream of the first automatic valve,
the first detachable structure is provided between the first automatic valve and the first manual valve, and
the second detachable structure is provided between the second automatic valve and the second manual valve.

16. The source material collection system of claim 2, wherein the trap structure is provided with an inlet for the process gas installed at an upper end of the trap structure and an outlet for the process gas installed at a lower end of the trap structure, and
the trap structure is configured such that the process gas flows downward inside the trap structure from the inlet to the outlet and such that the metal-containing source material is dripped from the outlet to the storage structure.

17. The source material collection system of claim 16, wherein the trap structure is further configured to be cooled by a refrigerant, and
a gas-contacting surface in the trap structure where the metal-containing source material condenses is a vertical surface.

18. The source material collection system of claim 1, wherein a temperature of the heating structure is set such that the viscosity of the metal-containing source material is equal to or lower than a predetermined viscosity and such that a vapor pressure of the metal-containing source material is equal to or lower than a predetermined pressure.

19. A substrate processing apparatus comprising:
a process chamber in which a substrate disposed therein is processed;
a metal-containing gas supplier configured to supply a process gas containing a metal-containing source material into the process chamber; and
a source material collection system configured to collect the metal-containing source material from the process gas exhausted from the process chamber by a pump,
wherein the source material collection system comprises:
an exhaust pipe through which the process gas exhausted by the pump is guided;
a trap structure provided in a first exhaust line constituting the exhaust pipe and configured to recover the metal-containing source material from the process gas; and
a heating structure configured to heat the trap structure in accordance with a viscosity of the metal-containing source material.

20. A source material collection method comprising:
a step of exhausting a process gas containing a metal-containing source material from a process chamber through an exhaust pipe;
a step of collecting the metal-containing source material from the process gas by a trap structure provided in a first exhaust line constituting the exhaust pipe; and
a step of heating the trap structure by the heating structure in accordance a viscosity of the metal-containing source material and dripping the metal-containing source material in the trap structure out of the trap structure.

21. A method of manufacturing a semiconductor device, comprising:
a step of exhausting a process gas containing a metal-containing source material from a process chamber through an exhaust pipe;
a step of collecting the metal-containing source material from the process gas by a trap structure provided in a first exhaust line constituting the exhaust pipe; and
a step of heating the trap structure by the heating structure in accordance a viscosity of the metal-containing source material and dripping the metal-containing source material in the trap structure out of the trap structure.
